# EUROPEAN PATENT SPECIFICATION

(11) **EP 4 235 957 B1**
(45) Date of publication and mention of the grant of the patent: **11.11.2026**
(21) Application number: 22181317.3
(22) Date of filing: 27.06.2022
(51) Int. Cl.: H01P 5/08, H01P 3/00, H01P 3/08

(54) **ELECTRIC DEVICE AND ITS RADIO-FREQUENCY TRANSMISSION LINE**
ELEKTRISCHE VORRICHTUNG UND DEREN HOCHFREQUENZÜBERTRAGUNGSLEITUNG
DISPOSITIF ÉLECTRIQUE ET SA LIGNE DE TRANSMISSION DE FRÉQUENCE RADIO

(30) Priority: 18.02.2022 CN 202210153026
(43) Date of publication of application: 30.08.2023
(73) Proprietor: Beijing Xiaomi Mobile Software Co., Ltd., Beijing 100085 (CN)
(72) Inventor: LIANG, Peiyu, Beijing 100085 (CN); LIU, Tianbo, Beijing 100085 (CN); MU, Mengtian, Beijing 100085 (CN)
(74) Representative: Dehns Germany Partnerschaft mbB

(56) References cited:
- JP-A- 2001 144 837
- US-A1- 2014 176 266
- US-A1- 2021 288 390
- US-B2- 10 833 397
- US-B2- 7 907 415
- "Transmission Line Design Handbook", 1 January 1991, ARTECH HOUSE, Norwood, MA, USA, ISBN: 978-0-89006-436-8, article WADELL BRIAN C.: "Transmission Line Components and Discontinuities", pages: 353 - 353, XP093273671
- "The Art and Science of Ultrawideband Antennas 2nd Edition", 1 January 2015, ARTECH HOUSE, Boston, MA, USA, ISBN: 978-1-60807-955-1, article HANS G. SCHANTZ: "Broadband Matching", pages: 170 - 175, XP055513146
- JUNO KIM ET AL: "Millimeter-Wave Silicon MMIC Interconnect and Coupler Using Multilayer Polyimide Technology", IEEE TRANSACTIONS ON MICROWAVE THEORY AND TECHNIQUES, IEEE, USA, vol. 48, no. 9, 1 September 2000 (2000-09-01), XP011038066, ISSN: 0018-9480
- CARLOS A DONADO MORCILLO ET AL: "An Ultra-Thin, High-Power, and Multilayer Organic Antenna Array With T/R Functionality in the $X$ -Band", IEEE TRANSACTIONS ON MICROWAVE THEORY AND TECHNIQUES, IEEE, USA, vol. 60, no. 12, 1 December 2012 (2012-12-01), pages 3856 - 3867, XP011481201, ISSN: 0018-9480, DOI: 10.1109/TMTT.2012.2218119

## Description

### TECHNICAL FIELD

The present invention relates to a field of electronic devices, and more particularly to an electronic device and its radio-frequency transmission line.

### BACKGROUND

Antennas of electronic devices that cannot be folded are arranged as metal frames around the electronic devices. For foldable 5G electronic devices, a pivot shaft is arranged at a side of the electronic device in a folded state. US10833397B2 discloses an electronic device. The electronic device may comprise a first structure and a second structure mutually foldably connected with the first structure about a first axis extending in a first direction. A wireless communication circuit of the electronic device is electrically connected with a first radiator and a second radiator and is electrically separated from the second radiator in a folded state. Any one of JP2001144837A and US7907415B2 discloses a foldable mobile phone, wherein each half of the mobile phone comprises a PCB, and wherein said PCBs are connected via an RF transmission line formed on a flexible substrate.

US2021288390A1 discloses a transmission line member, which includes a base body extending along a transmission direction of a high-frequency signal, and a first transmission line, a second transmission line, and a third transmission line. The base body includes a first portion including the first transmission line, a second portion including the second transmission line, and a third portion including the third transmission line. The second portion is connected between the first and third portions. A thickness of the second portion is smaller than a thickness of the first and third portions. The second transmission line includes only a conductor pattern extending more in the transmission direction than in a direction of the thickness.

### SUMMARY

The present invention seeks to solve at least one of the problems existing in the related art to at least some extent. To this end, embodiments of the present invention propose an electronic device and its radio-frequency transmission line.

According to one aspect, there is provided an electronic device as defined by claim 1.

The radio-frequency transmission line according to embodiments of the present invention has advantages of continuous impedance after several bends and high signal transmission quality after bending.

Optionally, the radio-frequency transmission line includes 2N+1 band-shaped line segments and 2N coplanar waveguide segments arranged alternately and connected sequentially in the extending direction, in which N is an integer greater than or equal to 1, each coplanar waveguide segment is located between two adjacent band-shaped line segments in the extending direction.

Optionally, the band-shaped line segments include a first band-shaped line segment, a second band-shaped line segment and a third band-shaped line segment arranged sequentially in the extending direction; the coplanar waveguide segments include a first coplanar waveguide segment located between the first band-shaped line segment and the second band-shaped line segment in the extending direction, the first coplanar waveguide segment being coupled to each of the first band-shaped line segment and the second band-shaped line segment; and a second coplanar waveguide segment located between the second band-shaped line segment and the third band-shaped line segment in the extending direction, the second coplanar waveguide segment being coupled to each of the second band-shaped line segment and the third band-shaped line segment.

Optionally, each of the first coplanar waveguide segment and the second coplanar waveguide segment has a length less than or equal to a first preset value.

Optionally, the band-shaped line segments include a first band-shaped line segment, a second band-shaped line segment, a third band-shaped line segment, a fourth band-shaped line segment and a fifth band-shaped line segment arranged sequentially in the extending direction; the coplanar waveguide segments include a first coplanar waveguide segment located between the first band-shaped line segment and the second band-shaped line segment in the extending direction, the first coplanar waveguide segment being coupled to each of the first band-shaped line segment and the second band-shaped line segment; a second coplanar waveguide segment located between the second band-shaped line segment and the third band-shaped line segment in the extending direction, the second coplanar waveguide segment being coupled to each of the second band-shaped line segment and the third band-shaped line segment; a third coplanar waveguide segment located between the third band-shaped line segment and the fourth band-shaped line segment in the extending direction, the third coplanar waveguide segment being coupled to each of the third band-shaped line segment and the fourth band-shaped line segment; and a fourth coplanar waveguide segment located between the fourth band-shaped line segment and the fifth band-shaped line segment in the extending direction, the fourth coplanar waveguide segment being coupled to each of the fourth band-shaped line segment and the fifth band-shaped line segment.

Optionally, each of the first coplanar waveguide segment, the second coplanar waveguide segment, the third coplanar waveguide segment and the fourth coplanar waveguide segment has a length greater than or equal to a second preset value and less than or equal to a third preset value.

Optionally, each of the second band-shaped line segment and the fourth band-shaped line segment has a length less than or equal to a fourth preset value.

Optionally, each coplanar waveguide segment has a metal trace layer including: a base part, each base part having a width greater than a width of the metal trace layer of the band-shaped line segment; a first transition part having a first end part coupled to the metal trace layer of a corresponding band-shaped line segment and a second end part coupled to the base part, in which the first end part of the first transition part has a width equal to the width of the metal trace layer of the corresponding band-shaped line segment, the second end part of the first transition part has a width equal to the width of the base part, the first transition part has a width increasing in the extending direction and along a direction towards the base part; and a second transition part having a first end part coupled to the metal trace layer of a corresponding band-shaped line segment and a second end part coupled to the base part, the base part being located between the first transition part and the second transition part in the extending direction, in which the first end part of the second transition part has a width equal to the width of the metal trace layer of the corresponding band-shaped line segment, the second end part of the second transition part has a width equal to the width of the base part, the second transition part has a width decreasing in the extending direction and along a direction away from the base part.

Optionally, the width of the first transition part increases gradually in the extending direction and along the direction towards the base part; and the width of the second transition part decreases gradually in the extending direction and along the direction away from the base part.

The radio-frequency transmission line includes a first metal ground assembly including a first modified polyimide layer and a first metal ground layer arranged on the first modified polyimide layer; a second metal ground assembly including a second modified polyimide layer and a second metal ground layer arranged on the second modified polyimide layer; and a metal trace assembly including a third modified polyimide layer and a metal trace layer arranged on the third modified polyimide layer, the first metal ground layer, the first modified polyimide layer, the metal trace layer, the third modified polyimide layer, the second metal ground layer and the second modified polyimide layer being arranged sequentially in a thickness direction of the radio-frequency transmission line, in which the first metal ground layer has a first through hole therethrough in the thickness direction, the second metal ground layer has a second through hole therethrough in the thickness direction, the first through hole and the second through hole are opposite in the thickness direction, a portion of the radio-frequency transmission line opposite the first through hole in the thickness direction constitutes the coplanar waveguide segment, and the band-shaped line segment of the radio-frequency transmission line is staggered with the first through hole in the thickness direction.

### BRIEF DESCRIPTION OF THE DRAWINGS

FIG. 1 is a schematic view of an electronic device according to an embodiment of the present invention.
FIG. 2 is a schematic view of a radio-frequency transmission line according to an embodiment of the present invention.
FIG. 3 is a schematic view of a first metal ground layer (a second metal ground layer) of a radio-frequency transmission line according to an embodiment of the present invention.
FIG. 4 is a schematic view of a metal trace layer of a radio-frequency transmission line according to an embodiment of the present invention.
FIG. 5 is a schematic view of a radio-frequency transmission line according to another embodiment of the present invention.
FIG. 6 is a schematic view of a first metal ground layer (a second metal ground layer) of a radio-frequency transmission line according to another embodiment of the present invention.
FIG. 7 is a schematic view of a metal trace layer of a radio-frequency transmission line according to another embodiment of the present invention.
FIG. 8 is a sectional view taken along E-E in FIG. 5.
FIG. 9 is a sectional view taken along F-F in FIG. 5.
FIG. 10 is an S-parameter simulation result diagram of a radio-frequency transmission line according to an embodiment of the present invention.
FIG. 11 is an S 12-parameter simulation result diagram of a radio-frequency transmission line according to an embodiment of the present invention.

### DETAILED DESCRIPTION

Embodiments of the present invention will be described in detail below, and examples of the embodiments are shown in accompanying drawings. The embodiments described herein with reference to drawings are explanatory, illustrative, and used to generally understand the present invention. The embodiments shall not be construed to limit the present invention.

For foldable 5G electronic devices, a pivot shaft is arranged at a side of the electronic device in a folded state, thus antennas can only be arranged at the other three sides of the electronic device in the folded state. Such an antenna arrangement cannot meet the needs of multiple frequency bands.

In order to enable the foldable 5G electronic devices to operate in multiple frequency bands, several antennas need to be arranged at two sides of the pivot shafts of the electronic devices, and thus radio-frequency transmission lines need to pass through the pivot shafts. Existing foldable 5G electronic devices have defects of discontinuous impedance of the radio-frequency transmission lines.

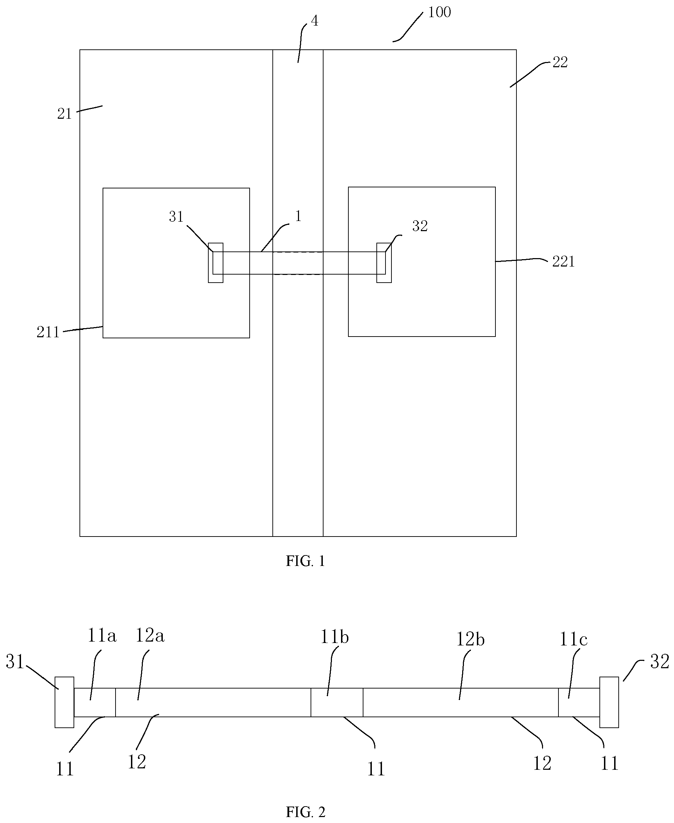

An electronic device 100 according to embodiments of the present invention will be described below with reference to the drawings. As illustrated in FIGS. 1 to 9, the electronic device 100 according to embodiments of the present invention includes a first body 21, a second body 22, and a radio-frequency transmission line 1.

The first body 21 and the second body 22 are rotatably connected relative to each other through a pivot shaft 4. That is, the first body 21 and the second body 22 are pivotally connected through the pivot shaft 4. That is to say, it is possible to keep the first body 21 still and rotate the second body 22, it is also possible to keep the second body 22 still and rotate the first body 21, and it is further possible to rotate both the first body 21 and the second body 22. The first body 21 includes a first motherboard 211, and the second body 22 includes a second motherboard 221.

A first end of the radio-frequency transmission line 1 is coupled to the first motherboard 211, and a second end of the radio-frequency transmission line 1 is coupled to the second motherboard 221. The radio-frequency transmission line 1 includes at least one band-shaped line segment 11 and at least two coplanar waveguide segments 12, and the band-shaped line segment 11 is coupled to the coplanar waveguide segments 12. One band-shaped line segment 11 is located between two coplanar waveguide segments 12 in an extending direction of the radio-frequency transmission line 1. One band-shaped line segment 11 is coupled to the pivot shaft 4 to retain stationary relative to the pivot shaft 4. For example, the one band-shaped line segment 11 may be adhered to the pivot shaft 4, or the one band-shaped line segment 11 may be coupled to the pivot shaft 4 through a snap or a snapping slot. The coplanar waveguide segments 12 are spaced apart from a metal portion of the pivot shaft 4.

When at least one of the first body 21 and the second body 22 is rotated, the radio-frequency transmission line 1 is bent. If the whole radio-frequency transmission line employs a band-shaped line structure, a metal ground layer of the radio-frequency transmission line will break after several bends, resulting in discontinuous impedance of the radio-frequency transmission line. If the whole radio-frequency transmission line employs a coplanar waveguide structure, a portion of the radio-frequency transmission line is covered by the metal portion of the pivot shaft, resulting in discontinuous impedance of the radio-frequency transmission line.

In the electronic device 100 according to embodiments of the present invention, one band-shaped line segment 11 of the radio-frequency transmission line 1 is coupled to the pivot shaft 4, and hence the one band-shaped line segment 11 may be retained stationary relative to the pivot shaft 4. Thus, when the radio-frequency transmission line 1 is bent (at least one of the first body 21 and the second body 22 is rotated), the one band-shaped line segment 11 will not bend, to prevent a metal ground layer of the one band-shaped line segment 11 from breaking after several bends and further avoid discontinuous impedance of the band-shaped line segment 11.

In the electronic device 100 according to embodiments of the present invention, the coplanar waveguide segments 12 are spaced apart from the metal portion of the pivot shaft 4, thus the coplanar waveguide segments 12 may be prevented from being covered by the metal portion of the pivot shaft 4, to avoid discontinuous of the coplanar waveguide segments 12. For example, the coplanar waveguide segment 12 may not be opposite to the metal portion of the pivot shaft 4, to be spaced apart from the metal portion of the pivot shaft 4. Additionally, a spacer layer (e.g., a foam layer) may be arranged between the coplanar waveguide segment 12 and the pivot shaft 4, and thus the coplanar waveguide segment 12 is spaced apart from the metal portion of the pivot shaft 4.

Therefore, the radio-frequency transmission line 1 according to embodiments of the present invention has advantages of continuous impedance after several bends, high signal transmission quality after bending and the like, and can apply to foldable electronic devices. The electronic device 100 according to embodiments of the present invention has advantages of continuous impedance after several bends of the radio-frequency transmission line, high signal transmission quality after bending of the radio-frequency transmission line and the like.

As illustrated in FIGS. 1 to 9, the electronic device 100 according to embodiments of the present invention includes a first body 21, a second body 22, and a radio-frequency transmission line 1. The first body 21 and the second body 22 are rotatably connected relative to each other through a pivot shaft 4. The electronic device 100 according to embodiments of the present invention is a foldable electronic device. For example, the electronic device 100 according to embodiments of the present invention may be a mobile phone (a cell phone), a tablet computer, and the like.

The first body 21 includes a first motherboard 211, and the second body 22 includes a second motherboard 221. A first end of the radio-frequency transmission line 1 is coupled to the first motherboard 211, and a second end of the radio-frequency transmission line 1 is coupled to the second motherboard 221.

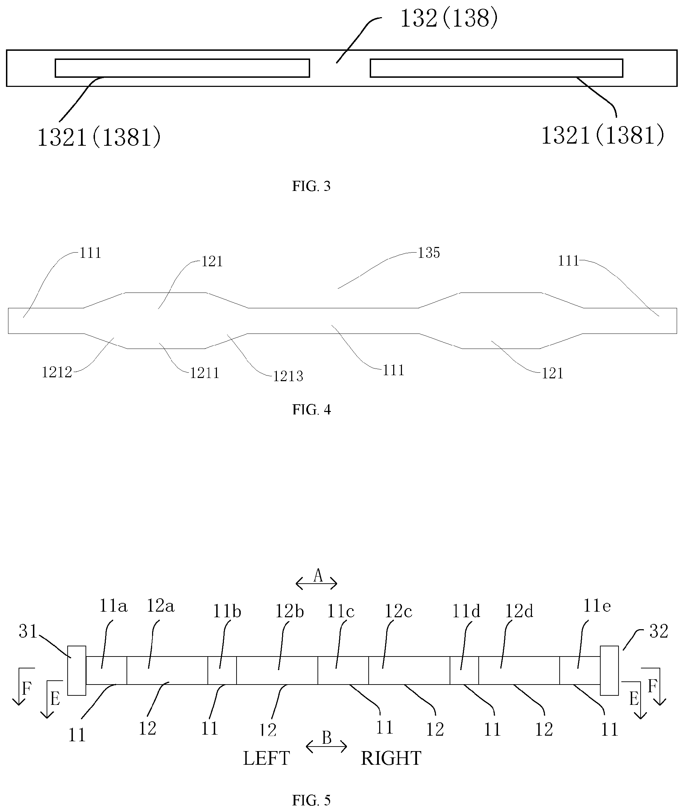

As illustrated in FIGS. 2 and 5, the radio-frequency transmission line 1 includes 2N+1 band-shaped line segments 11 and 2N coplanar waveguide segments 12. The 2N+1 band-shaped line segments 11 and the 2N coplanar waveguide segments 12 are alternately arranged in the extending direction of the radio-frequency transmission line 1. The 2N+1 band-shaped line segments 11 and the 2N coplanar waveguide segments 12 are connected sequentially. The extending direction of the radio-frequency transmission line 1 is represented by an arrow A in FIG. 5.

The radio-frequency transmission line 1 includes the 2N+1 band-shaped line segments 11 and the 2N coplanar waveguide segments 12, thus lengths of each band-shaped line segment 11 and each coplanar waveguide segment 12 may be controlled more conveniently and more effectively, to make structures of the radio-frequency transmission line 1 and the electronic device 100 more reasonable.

Optionally, each coplanar waveguide segment 12 is located between two adjacent band-shaped line segments 11 in the extending direction of the radio-frequency transmission line 1. Thus, one of the band-shaped line segments 11 may be coupled to the first motherboard 211, and another of the band-shaped line segments 11 may be coupled to the second motherboard 221.

Thus, the radio-frequency transmission line 1 may be coupled to the first motherboard 211 and the second motherboard 221 more conveniently and more easily. For example, one of the band-shaped line segments 11 is coupled to the first motherboard 211 through a first BTB (board-to-board) connector 31, and another of the band-shaped line segments 11 may be coupled to the second motherboard 221 through a second BTB connector 32.

As illustrated in FIGS. 2 to 4, in one embodiment of the present invention, the band-shaped line segments 11 includes a first band-shaped line segment 11a, a second band-shaped line segment 11b and a third band-shaped line segment 11c arranged sequentially in the extending direction of the radio-frequency transmission line 1. The first band-shaped line segment 11a is coupled to the first motherboard 211, and the third band-shaped line segment 11c is coupled to the second motherboard 221. For example, the first band-shaped line segments 11a is coupled to the first motherboard 211 through the first BTB connector 31, and the third band-shaped line segments 11c is coupled to the second motherboard 221 through the second BTB connector 32.

The second band-shaped line segment 11b is coupled to the pivot shaft 4 to stay stationary relative to the pivot shaft 4. The pivot shaft 4 is located between the first band-shaped line segment 11a and the third band-shaped line segment 11c in the extending direction of the radio-frequency transmission line 1. That is to say, the first band-shaped line segment 11a and the third band-shaped line segment 11c are located outside the pivot shaft 4. Thus, when the radio-frequency transmission line 1 is bent (at least one of the first body 21 and the second body 22 is rotated), the first band-shaped line segment 11a and the third band-shaped line segment 11c will not be bent, and also the second band-shaped line segment 11b coupled to the pivot shaft 4 will not be bent, such that the radio-frequency transmission line 1 still has continuous impedance after several bends and can transmit signals with high quality after bending. The coplanar waveguide segments 12 include a first coplanar waveguide segment 12a and a second coplanar waveguide segment 12b. The first coplanar waveguide segment 12a is located between the first band-shaped line segment 11a and the second band-shaped line segment 11b in the extending direction of the radio-frequency transmission line 1, and the first coplanar waveguide segment 12a is coupled to each of the first band-shaped line segment 11a and the second band-shaped line segment 11b. The second coplanar waveguide segment 12b is located between the second band-shaped line segment 11b and the third band-shaped line segment 11c in the extending direction of the radio-frequency transmission line 1, and the second coplanar waveguide segment 12b is coupled to each of the second band-shaped line segment 11b and the third band-shaped line segment 11c.

That is to say, the second band-shaped line segment 11b is located between the first coplanar waveguide segment 12a and the second coplanar waveguide segment 12b in the extending direction of the radio-frequency transmission line 1, and the second band-shaped line segment 11b is coupled to each of the first coplanar waveguide segment 12a and the second coplanar waveguide segment 12b.

The first coplanar waveguide segment 12a and the second coplanar waveguide segment 12b are spaced apart from the metal portion of the pivot shaft 4. Thus, the first coplanar waveguide segment 12a and the second coplanar waveguide segment 12b may be prevented from being covered by the metal portion of the pivot shaft 4, to avoid discontinuous impedance of the first coplanar waveguide segment 12a and the second coplanar waveguide segment 12b, and further avoid the discontinuous impedance of the radio-frequency transmission line 1.

Optionally, each of the first coplanar waveguide segment 12a and the second coplanar waveguide segment 12b has a length less than or equal to a first preset value. Thus, the radio-frequency transmission line 1 and the electronic device 100 may have no noise wave below 7.5GHz, i.e., they will not generate resonance point below 7.5GH, to reduce loss of the radio-frequency transmission line 1 and the electronic device 100.

Optionally, each of the first coplanar waveguide segment 12a and the second coplanar waveguide segment 12b has a length less than or equal to 12 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

Optionally, each of the first coplanar waveguide segment 12a and the second coplanar waveguide segment 12b has a length less than or equal to 11 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

Optionally, each of the first coplanar waveguide segment 12a and the second coplanar waveguide segment 12b has a length less than or equal to 10 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

Optionally, each of the first coplanar waveguide segment 12a and the second coplanar waveguide segment 12b has a length less than or equal to 8 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

For example, the length of each of the first coplanar waveguide segment 12a and the second coplanar waveguide segment 12b may be 5 millimeters, 5.5 millimeters, 6 millimeters, 6.5 millimeters, 7 millimeters, 7.5 millimeters, 8 millimeters, 8.5 millimeters, 9 millimeters, 9.5 millimeters, 10 millimeters, 10.5 millimeters, 11 millimeters, 11.5 millimeters or 12 millimeters.

Optionally, lengths of the first coplanar waveguide segment 12a and the second coplanar waveguide segment 12b may be equal to each other. Thus, the radio-frequency transmission line 1 and the electronic device 100 may have more reasonable structures. Lengths of the first band-shaped line segment 11a and the third band-shaped line segment I I c may be equal to each other. Thus, the radio-frequency transmission line 1 and the electronic device 100 may have more reasonable structures.

As illustrated in FIGS. 5 to 7, in another embodiment of the present invention, the band-shaped line segments 11 include a first band-shaped line segment 11a, a second band-shaped line segment 11b, a third band-shaped line segment 11c, a fourth band-shaped line segment 11d and a fifth band-shaped line segment 11e arranged sequentially in the extending direction of the radio-frequency transmission line 1. The first band-shaped line segment 11a is coupled to the first motherboard 211, and the fifth band-shaped line segment 11e is coupled to the second motherboard 221. For example, the first band-shaped line segment 11a is coupled to the first motherboard 211 through the first BTB connector 31, and the fifth band-shaped line segment 11e is coupled to the second motherboard 221 through the second BTB connector 32.

The third band-shaped line segment 11c is coupled to the pivot shaft 4 to stay stationary relative to the pivot shaft 4. The pivot shaft 4 is located between the first band-shaped line segment 11a and the fifth band-shaped line segment 11e in the extending direction of the radio-frequency transmission line 1. That is to say, the first band-shaped line segment 11a and the fifth band-shaped line segment 11e are located outside the pivot shaft 4. Thus, when the radio-frequency transmission line 1 is bent (at least one of the first body 21 and the second body 22 is rotated), the first band-shaped line segment 11a and the fifth band-shaped line segment 11e will not be bent, and also the third band-shaped line segment 11c coupled to the pivot shaft 4 will not be bent, such that the radio-frequency transmission line 1 still has continuous impedance after several bends and can transmit signals with high quality after bending. The coplanar waveguide segments include a first coplanar waveguide segment 12a, a second coplanar waveguide segment 12b, a third coplanar waveguide segment 12c, and a fourth coplanar waveguide segment 12d. The first coplanar waveguide segment 12a is located between the first band-shaped line segment 11a and the second band-shaped line segment 11b in the extending direction of the radio-frequency transmission line 1, and the first coplanar waveguide segment 12a is coupled to each of the first band-shaped line segment 11a and the second band-shaped line segment 11b. The second coplanar waveguide segment 12b is located between the second band-shaped line segment 11b and the third band-shaped line segment 11c in the extending direction of the radio-frequency transmission line 1, and the second coplanar waveguide segment 12b is coupled to each of the second band-shaped line segment 11b and the third band-shaped line segment 11c. The third coplanar waveguide segment 12c is located between the third band-shaped line segment 11c and the fourth band-shaped line segment 11d in the extending direction of the radio-frequency transmission line 1, and the third coplanar waveguide segment 12c is coupled to each of the third band-shaped line segment 11c and the fourth band-shaped line segment 11d. The fourth coplanar waveguide segment 12d is located between the fourth band-shaped line segment 11d and the fifth band-shaped line segment 11e in the extending direction of the radio-frequency transmission line 1, and the fourth coplanar waveguide segment 12d is coupled to each of the fourth band-shaped line segment 11d and the fifth band-shaped line segment 11e.

That is to say, the radio-frequency transmission line 1 includes the first band-shaped line segment 11a, the first coplanar waveguide segment 12a, the second band-shaped line segment 11b, the second coplanar waveguide segment 12b, the third band-shaped line segment 11c, the third coplanar waveguide segment 12c, the fourth band-shaped line segment 11d, the fourth coplanar waveguide segment 12d and the fifth band-shaped line segment 11e arranged sequentially in the extending direction. The first band-shaped line segment 11a, the first coplanar waveguide segment 12a, the second band-shaped line segment 11b, the second coplanar waveguide segment 12b, the third band-shaped line segment 11c, the third coplanar waveguide segment 12c, the fourth band-shaped line segment 11d, the fourth coplanar waveguide segment 12d and the fifth band-shaped line segment 11e are connected sequentially.

The first coplanar waveguide segment 12a, the second coplanar waveguide segment 12b, the third coplanar waveguide segment 12c and the fourth coplanar waveguide segment 12d are spaced apart from the metal portion of the pivot shaft 4. Thus, the first coplanar waveguide segment 12a, the second coplanar waveguide segment 12b, the third coplanar waveguide segment 12c and the fourth coplanar waveguide segment 12d may be prevented from being covered by the metal portion of the pivot shaft 4, to avoid discontinuous impedance of the first coplanar waveguide segment 12a, the second coplanar waveguide segment 12b, the third coplanar waveguide segment 12c and the fourth coplanar waveguide segment 12d, and further avoid the discontinuous impedance of the radio-frequency transmission line 1.

The radio-frequency transmission line 1 includes the first coplanar waveguide segment 12a, the second coplanar waveguide segment 12b, the third coplanar waveguide segment 12c and the fourth coplanar waveguide segment 12d, that is, the radio-frequency transmission line 1 includes four coplanar waveguide segments 12. Thus, the radio-frequency transmission line 1 and the electronic device 100 may have no noise wave below 7.5GHz, i.e., they will not generate resonance point below 7.5GH, to reduce loss of the radio-frequency transmission line 1 and the electronic device 100.

Optionally, the pivot shaft 4 has a first edge and a second edge opposite each other in the extending direction of the radio-frequency transmission line 1. The first coplanar waveguide segment 12a, the second band-shaped line segment 11b, the second coplanar waveguide segment 12b, the third band-shaped line segment 11c, the third coplanar waveguide segment 12c, the fourth band-shaped line segment 11d, the fourth coplanar waveguide segment 12d are located between the first edge and the second edge in the extending direction of the radio-frequency transmission line 1.

Since the radio-frequency transmission line 1 includes many band-shaped line segments 11 and coplanar waveguide segments 12, the second band-shaped line segment 11b and the fourth band-shaped line segment 11d may have relatively small lengths. Thus, when the radio-frequency transmission line 1 is bent (at least one of the first body 21 and the second body 22 is rotated), the second band-shaped line segment 11b and the fourth band-shaped line segment 11d will only be slightly bent, which will not cause breaking of metal ground layers of the second band-shaped line segment 11b and the fourth band-shaped line segment 11d after several bends, avoiding discontinuous impedance of the band-shaped line segment 11.

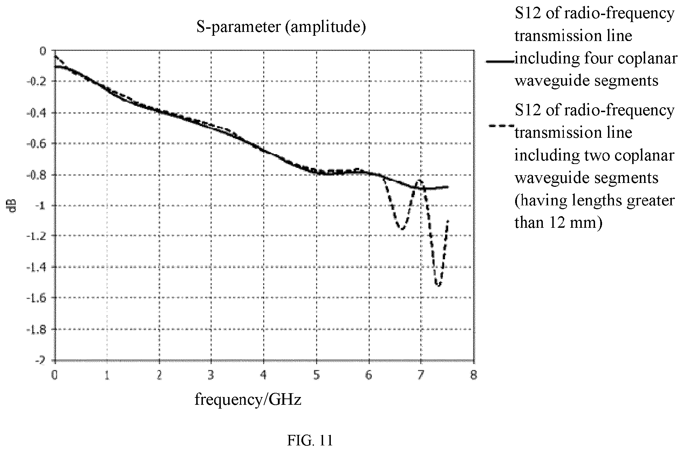

As illustrated in FIG. 11, the radio-frequency transmission line 1 including the first coplanar waveguide segment 12a and the second coplanar waveguide segment 12b (each of the first coplanar waveguide segment 12a and the second coplanar waveguide segment 12b has a length greater than 12 millimeters) generates two noise waves in a range of 6GHz-7.5 GHz, resulting in relatively large loss. The radio-frequency transmission line 1 including the first coplanar waveguide segment 12a, the second coplanar waveguide segment 12b, the third coplanar waveguide segment 12c, and the fourth coplanar waveguide segment 12d will not generate noise wave below 7.5GHz, to reduce the loss.

Optionally, each of the first coplanar waveguide segment 12a, the second coplanar waveguide segment 12b, the third coplanar waveguide segment 12c and the fourth coplanar waveguide segment 12d has a length greater than or equal to a second preset value and less than or equal to a third preset value. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

Optionally, each of the first coplanar waveguide segment 12a, the second coplanar waveguide segment 12b, the third coplanar waveguide segment 12c and the fourth coplanar waveguide segment 12d has a length greater than or equal to 12 millimeters and less than or equal to 17 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

Optionally, each of the first coplanar waveguide segment 12a, the second coplanar waveguide segment 12b, the third coplanar waveguide segment 12c and the fourth coplanar waveguide segment 12d has a length greater than or equal to 13 millimeters and less than or equal to 16 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

Optionally, each of the first coplanar waveguide segment 12a, the second coplanar waveguide segment 12b, the third coplanar waveguide segment 12c and the fourth coplanar waveguide segment 12d has a length greater than or equal to 13.5 millimeters and less than or equal to 15.5 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

Optionally, each of the first coplanar waveguide segment 12a, the second coplanar waveguide segment 12b, the third coplanar waveguide segment 12c and the fourth coplanar waveguide segment 12d has a length greater than or equal to 14 millimeters and less than or equal to 15 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

Optionally, each of the first coplanar waveguide segment 12a, the second coplanar waveguide segment 12b, the third coplanar waveguide segment 12c and the fourth coplanar waveguide segment 12d has a length greater than or equal to 14.1 millimeters and less than or equal to 14.4 millimeters. Thus, the radio-frequency transmission line 1 and the electronic device 100 may be further ensured to have no noise wave below 7.5GHz, i.e., they are further ensured not to generate resonance point below 7.5GH, to further reduce loss of the radio-frequency transmission line 1 and the electronic device 100.

For example, the length of each of the first coplanar waveguide segment 12a, the second coplanar waveguide segment 12b, the third coplanar waveguide segment 12c and the fourth coplanar waveguide segment 12d may be 12 millimeters, 12.5 millimeters, 13 millimeters, 13.5 millimeters, 14 millimeters, 14.1 millimeters, 14.2 millimeters, 14.3 millimeters, 14.4 millimeters, 14.5 millimeters, 14.6 millimeters, 14.7 millimeters, 14.8 millimeters, 14.9 millimeters, 15 millimeters, 15.5 millimeters, 16 millimeters, 16.5 millimeters or 17 millimeters.

Optionally, lengths of each of the first coplanar waveguide segment 12a, the second coplanar waveguide segment 12b, the third coplanar waveguide segment 12c and the fourth coplanar waveguide segment 12d may be equal to each other. Thus, the radio-frequency transmission line 1 and the electronic device 100 may have more reasonable structures.

Lengths of the first band-shaped line segment 11a and the fifth band-shaped line segment 11e may be equal to each other. Thus, the radio-frequency transmission line 1 and the electronic device 100 may have more reasonable structures. Lengths of the second band-shaped line segment 11b and the fourth band-shaped line segment 11d may be equal to each other. Thus, the radio-frequency transmission line 1 and the electronic device 100 may have more reasonable structures.

Optionally, each of the second band-shaped line segment 11b and the fourth band-shaped line segment 11d has a length less than or equal to a fourth preset value. Thus, when the radio-frequency transmission line 1 is bent (at least one of the first body 21 and the second body 22 is rotated), the second band-shaped line segment 11b and the fourth band-shaped line segment 11d will only be slightly bent.

Each of the second band-shaped line segment 11b and the fourth band-shaped line segment 11d has a length less than or equal to the fourth preset value, the degree of bending of the second band-shaped line segment 11b and the fourth band-shaped line segment 11d is greatly reduced, to prevent the metal ground layers of the second band-shaped line segment 11b and the fourth band-shaped line segment 11d from breaking, further ensuring that the radio-frequency transmission line 1 still has continuous impedance after several bends and can transmit signals with high quality after bending.

Optionally, each of the second band-shaped line segment 11b and the fourth band-shaped line segment 11d has a length less than or equal to 6 millimeters. Thus, it may be further ensured that the radio-frequency transmission line 1 still has continuous impedance after several bends and can transmit signals with high quality after bending.

Optionally, each of the second band-shaped line segment 11b and the fourth band-shaped line segment 11d has a length less than or equal to 5 millimeters. Thus, it may be further ensured that the radio-frequency transmission line 1 still has continuous impedance after several bends and can transmit signals with high quality after bending.

Optionally, each of the second band-shaped line segment 11b and the fourth band-shaped line segment 11d has a length less than or equal to 4.5 millimeters. Thus, it may be further ensured that the radio-frequency transmission line 1 still has continuous impedance after several bends and can transmit signals with high quality after bending.

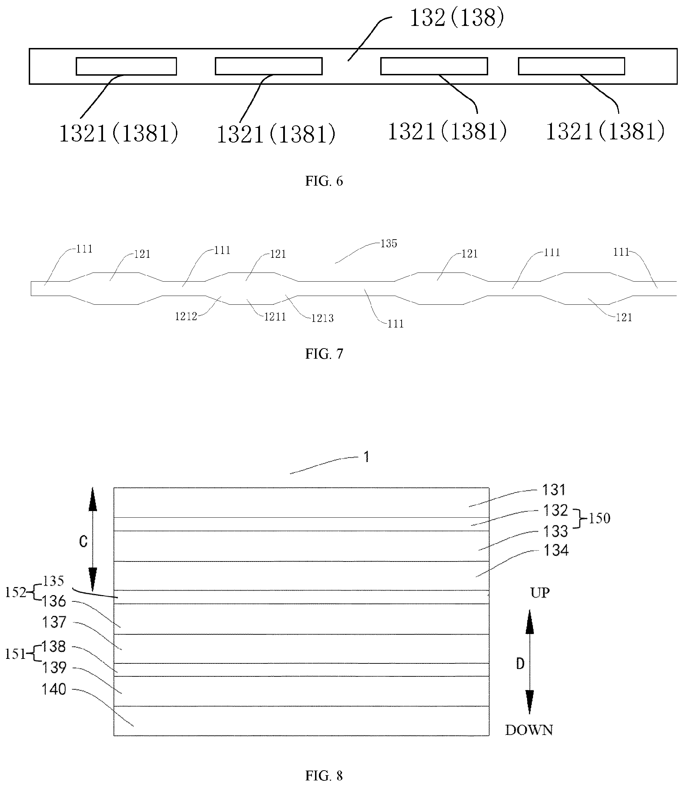

As illustrated in FIG. 7, the metal trace layer 121 of each coplanar waveguide segment 12 includes a base part 1211, a first transition part 1212 and a second transition part 1213. A width of each base part 1211 is greater than a width of the metal trace layer 111 of the band-shaped line segment 11. The base part 1211 is located between the first transition part 1212 and the second transition part 1213 in the extending direction of the radio-frequency transmission line 1.

A first end part of the first transition part 1212 is coupled to the metal trace layer 111 of a corresponding band-shaped line segment 11, and a first end part of the second transition part 1213 is coupled to the metal trace layer 111 of a corresponding band-shaped line segment 11. That is to say, the first transition part 1212 and the second transition part 1213 of the coplanar waveguide segment 12 are coupled to the metal trace layers 111 of the band-shaped line segments 11 adjacent to this coplanar waveguide segment 12. For example, the first end part of the first transition part 1212 of the first coplanar waveguide segment 12a is coupled to the metal trace layer 111 of the first band-shaped line segment 11a, and the first end part of the second transition part 1213 of the first coplanar waveguide segment 12a is coupled to the metal trace layer 111 of the second band-shaped line segment 11b.

A second end part of the first transition part 1212 is coupled to the base part 1211, and a second end part of the second transition part 1213 is coupled to the base part 1211. A width of the first end part of the first transition part 1212 is equal to a width of the metal trace layer 111 of a corresponding band-shaped line segment 11, and a width of the second end part of the first transition part 1212 is equal to a width of the base part 1211. A width of the first end part of the second transition part 1213 is equal to a width of the metal trace layer 111 of a corresponding band-shaped line segment 11, and a width of the second end part of the second transition part 1213 is equal to the width of the base part 1211.

That is to say, the width of the first end part of the first transition part 1212 is equal to the width of the metal trace layer 111 of the band-shaped line segment 11 coupled to it, and the width of the first end part of the second transition part 1213 is equal to the width of the metal trace layer 111 of the band-shaped line segment 11 coupled to it.

The width of the first transition part 1212 increases in the extending direction of the radio-frequency transmission line 1 and along a direction towards the base part 1211, and the width of the second transition part 1213 decreases in the extending direction of the radio-frequency transmission line 1 and along a direction away from the base part 1211. Thus, the radio-frequency transmission line 1 and the electronic device 100 may have more reasonable structures and more continuous impedance.

For example, the extending direction of the radio-frequency transmission line 1 is consistent with a left-right direction, the first transition part 1212 is located at a left side of the base part 1211, and the second transition part 1213 is located at a right side of the base part 1211. The width of the first transition part 1212 increases from left to right, and the width of the second transition part 1213 decreases from left to right. The left-right direction is represented by an arrow B in FIG. 5.

In a width direction of the radio-frequency transmission line 1 (a width direction of the metal trace layer 111), two sides of the metal trace layer 111 of the band-shaped line segment 11 may be metal ground; and in the width direction of the radio-frequency transmission line 1 (a width direction of the metal trace layer 121), two sides of the metal trace layer 121 of the coplanar waveguide segment 12 may be metal ground.

Optionally, the width of the metal trace layer 111 of the band-shaped line segment 11 is greater than or equal to 0.08 millimeters and less than or equal to 0.2 millimeters. Optionally, the width of the metal trace layer 111 of the band-shaped line segment 11 is greater than or equal to 0.085 millimeters and less than or equal to 0.15 millimeters. Optionally, the width of the metal trace layer 111 of the band-shaped line segment 11 is greater than or equal to 0.9 millimeters and less than or equal to 0.1 millimeters. Thus, the radio-frequency transmission line 1 and the electronic device 100 may have more reasonable structures and more continuous impedance.

Optionally, the width of the base part 1211 is greater than or equal to 0.3 millimeters and less than or equal to 0.5 millimeters. Optionally, the width of the base part 1211 is greater than or equal to 0.33 millimeters and less than or equal to 0.47 millimeters. Optionally, the width of the base part 1211 is greater than or equal to 0.35 millimeters and less than or equal to 0.45 millimeters. Optionally, the width of the base part 1211 is 0.4 millimeters. Thus, the radio-frequency transmission line 1 and the electronic device 100 may have more reasonable structures and more continuous impedance.

As illustrated in FIG. 7, the width of the first transition part 1212 gradually increases in the extending direction of the radio-frequency transmission line 1 and along a direction towards the base part 1211, and the width of the second transition part 1213 gradually decreases in the extending direction of the radio-frequency transmission line 1 and along a direction away from the base part 1211. Thus, the radio-frequency transmission line 1 and the electronic device 100 may have more reasonable structures and more continuous impedance.

Optionally, projection of each of the first transition part 1212 and the second transition part 1213 on a first plane is an isosceles trapezoid, and the first plane is perpendicular to a thickness direction of the radio-frequency transmission line 1. Thus, the radio-frequency transmission line 1 and the electronic device 100 may have more reasonable structures and more continuous impedance.

An interior angle of a base of the isosceles trapezoid adjacent to the corresponding band-shaped line segment 11 is greater than or equal to 100 degrees and less than or equal to 120 degrees. In other words, an angle between the base of the isosceles trapezoid adjacent to the corresponding band-shaped line segment 11 and a leg of the isosceles trapezoid is greater than or equal to 100 degrees and less than or equal to 120 degrees. Thus, the radio-frequency transmission line 1 and the electronic device 100 may have more reasonable structures and more continuous impedance.

For example, an interior angle of the base of the first transition part 1212 of the first coplanar waveguide segment 12a adjacent to the first band-shaped line segment 11a is greater than or equal to 100 degrees and less than or equal to 120 degrees, and an interior angle of the base of the second transition part 1213 of the first coplanar waveguide segment 12a adjacent to the second band-shaped line segment 11b is greater than or equal to 100 degrees and less than or equal to 120 degrees.

Optionally, the interior angle of the base of the isosceles trapezoid adjacent to the corresponding band-shaped line segment 11 is greater than or equal to 103 degrees and less than or equal to 115 degrees. Thus, the radio-frequency transmission line 1 and the electronic device 100 may have more reasonable structures and more continuous impedance.

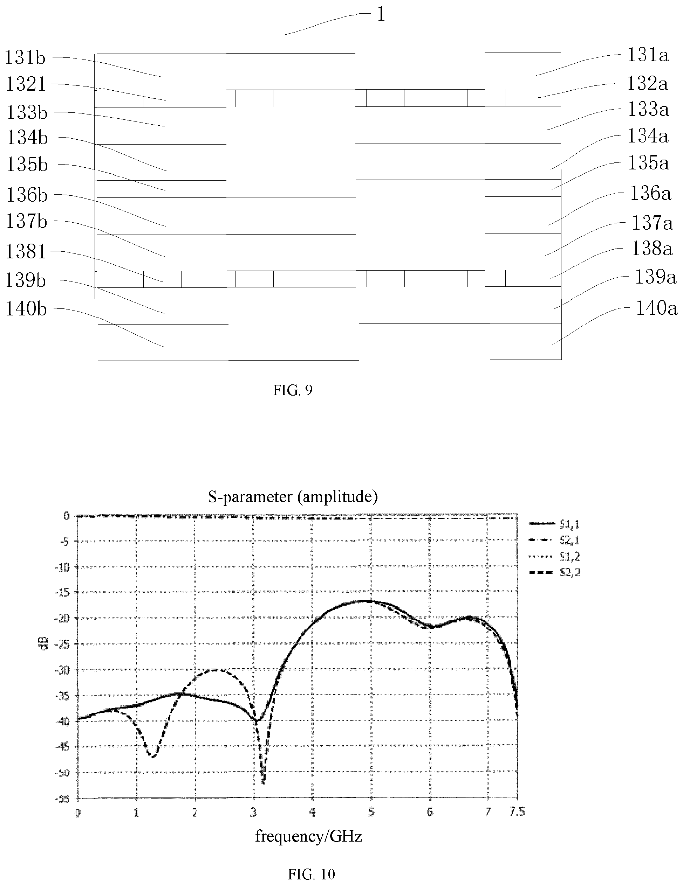

As illustrated in FIGS. 8 and 9, the radio-frequency transmission line 1 includes a first metal ground assembly 150, a second metal ground assembly 151 and a metal trace assembly 152. The first metal ground assembly 150 includes a first modified polyimide layer 133 and a first metal ground layer 132 arranged on the first modified polyimide layer 133, the second metal ground assembly 151 includes a second modified polyimide layer 139 and a second metal ground layer 138 arranged on the second modified polyimide layer 139, and the metal trace assembly 152 includes a third modified polyimide layer 136 and a metal trace layer 135 arranged on the third modified polyimide layer 136. That is to say, the metal trace layer 135 includes the metal trace layer 111 of the band-shaped line segment 11 and the metal trace layer 121 of the coplanar waveguide segment 12.

The first metal ground layer 132, the first modified polyimide layer 133, the metal trace layer 135, the third modified polyimide layer 136, the second metal ground layer 138 and the second modified polyimide layer 139 are arranged sequentially in the thickness direction of the radio-frequency transmission line 1. For example, the thickness direction of the radio-frequency transmission line 1 is consistent with an up-and-down direction, the first metal ground layer 132, the first modified polyimide layer 133, the metal trace layer 135, the third modified polyimide layer 136, the second metal ground layer 138 and the second modified polyimide layer 139 are arranged sequentially from top to bottom. The thickness direction of the radio-frequency transmission line 1 is represented by an arrow C in FIG. 8; and the up-and-down direction is represented by an arrow D in FIG. 8.

The first metal ground layer 132 has a first through hole 1321 therethrough in the thickness direction of the radio-frequency transmission line 1, and the second metal ground layer 138 has a second through hole 1381 therethrough in the thickness direction of the radio-frequency transmission line 1. The first through hole 1321 and the second through hole 1381 are opposite in the thickness direction of the radio-frequency transmission line 1. A portion of the radio-frequency transmission line 1 opposite the first through hole 1321 (the second through hole 1381) in the thickness direction constitutes the coplanar waveguide segment 12, and the band-shaped line segment 11 of the radio-frequency transmission line 11 and the first through hole 1321 (the second through hole 1381) are staggered in the thickness direction of the radio-frequency transmission line 1.

That that is to say, the first metal ground layer 132 of the band-shaped line segment 11 does not have the first through hole 1321, the second metal ground layer 138 of the band-shaped line segment 11 does not have the second through hole 1381; the coplanar waveguide segment 12 is opposite the first through hole 1321 and the second through hole 1381 in the thickness direction of the radio-frequency transmission line 1 such that the coplanar waveguide segment 12 does not have the first metal ground layer 132 and the second metal ground layer 138. For example, each of the first coplanar waveguide segment 12a, the second coplanar waveguide segment 12b, the third coplanar waveguide segment 12c and the fourth coplanar waveguide segment 12d is opposite one first through hole 1321 and one second through hole 1381 in the thickness direction of the radio-frequency transmission line 1.

In other words, each band-shaped line segment 11 includes the first modified polyimide layer 133a, the first metal ground layer 132a arranged on the first modified polyimide layer 133a, the second modified polyimide layer 139a, the second metal ground layer 138a arranged on the second modified polyimide layer 139a, the third modified polyimide layer 136a, and the metal trace layer 135a arranged on the third modified polyimide layer 136a. The first metal ground layer 132a, the first modified polyimide layer 133a, the metal trace layer 135a, the third modified polyimide layer 136a, the second metal ground layer 138a and the second modified polyimide layer 139a are arranged sequentially in the thickness direction of the radio-frequency transmission line 1.

Each coplanar waveguide segment 12 includes the first modified polyimide layer 133b, a second modified polyimide layer 139b, a metal trace layer 135b arranged on the third modified polyimide layer 136b, and the third modified polyimide layer 136b. The first modified polyimide layer 133b, the metal trace layer 135b, the third modified polyimide layer 136b, and the second modified polyimide layer 139b are arranged sequentially in the thickness direction of the radio-frequency transmission line 1. For example, the first modified polyimide layer 133 includes the first modified polyimide layer 133a and the first modified polyimide layer 133b.

The first metal ground layer 132, the second metal ground layer 138 and the metal trace layer 135 are arranged on modified polyimide layers, bendability of the radio-frequency transmission line 1 may be greatly improved, and bending times of the radio-frequency transmission line 1 can reach more than 200,000 times.

As illustrated in FIGS. 8 and 9, the radio-frequency transmission line 1 further includes a first adhesive layer 134 and a second adhesive layer 137. The first adhesive layer 134 is arranged between the first metal ground assembly 150 and the metal trace assembly 152, and the second adhesive layer 137 is arranged between the second metal ground assembly 151 and the metal trace assembly 152.

That is to say, the first adhesive layer 134 is located between the first modified polyimide layer 133 and the metal trace layer 135 in the thickness direction of the radio-frequency transmission line 1, and the second adhesive layer 137 is located between the third modified polyimide layer 136 and the second metal ground layer 138 in the thickness direction of the radio-frequency transmission line 1. Arrangement of the first adhesive layer 134 and the second adhesive layer 137 may make the structure of the radio-frequency transmission line 1 firmer.

As illustrated in FIGS. 8 and 9, the radio-frequency transmission line 1 further includes a first cover film layer 131 and a second cover film layer 140. The first cover film layer 131 is arranged on the first metal ground assembly 150, and the second cover film layer 140 is arranged on the second metal ground assembly 151. The first metal ground assembly 150 is located between the first cover film layer 131 and the metal trace assembly 152 in the thickness direction of the radio-frequency transmission line 1, and the second metal ground assembly 151 is located between the second cover film layer 140 and the metal trace assembly 152 in the thickness direction of the radio-frequency transmission line 1.

In other words, the first metal ground layer 132 is located between the first cover film layer 131 and the first modified polyimide layer 133 in the thickness direction of the radio-frequency transmission line 1, and the second modified polyimide layer 139 is located between the second cover film layer 140 and the second metal ground layer 138 in the thickness direction of the radio-frequency transmission line 1. Arrangement of the first cover film layer 131 and the second cover film layer 140 may make the structure of the radio-frequency transmission line 1 more reasonable.

As illustrated in FIG. 9, each band-shaped line segment 11 includes the first cover film layer 131a, the first metal ground layer 132a, the first modified polyimide layer 133a, the first adhesive layer 134a, the metal trace layer 135a, the third modified polyimide layer 136a, the second adhesive layer 137a, the second metal ground layer 138a, the second modified polyimide layer 139a and the second cover film layer 140a are arranged sequentially in the thickness direction of the radio-frequency transmission line 1 (e.g., from top to bottom).

Each coplanar waveguide segment 12 includes the first cover film layer 131b, the first modified polyimide layer 133b, the first adhesive layer 134b, the metal trace layer 135b, the third modified polyimide layer 136b, the second adhesive layer 137b, the second modified polyimide layer 139b and the second cover film layer 140b are arranged sequentially in the thickness direction of the radio-frequency transmission line 1 (e.g., from top to bottom). The first through hole 1321 is formed between the first cover film layer 131b and the first modified polyimide layer 133b, and the second through hole 1381 is formed between the second cover film layer 137b and the second modified polyimide layer 139b.

In the specification, it is to be understood that terms such as "central," "longitudinal," "lateral," "length," "width," "thickness," "upper," "lower," "front," "rear," "left," "right," "vertical," "horizontal," "top," "bottom," "inner," "outer," "clockwise," "counterclockwise," "axial," "radial" and "circumferential" should be construed to refer to the orientation as then described or as shown in the drawings under discussion. These relative terms are for convenience of description and do not require that the present invention be constructed or operated in a particular orientation.

In addition, terms such as "first" and "second" are used herein for purposes of description and are not intended to indicate or imply relative importance or significance. Thus, the feature defined with "first" and "second" may comprise one or more of this feature. In the description of the present invention, "a plurality of" means two or more than two, unless specified otherwise.

In the present invention, unless specified or limited otherwise, the terms "mounted," "connected," "coupled," "fixed" and the like are used broadly, and may be, for example, fixed connections, detachable connections, or integral connections; may also be mechanical or electrical connections; may also be direct connections or indirect connections via intervening structures; may also be inner communications of two elements. The above terms can be understood by those skilled in the art according to specific situations.

In the present invention, unless specified or limited otherwise, a structure in which a first feature is "on" or "below" a second feature may include an embodiment in which the first feature is in direct contact with the second feature, and may also include an embodiment in which the first feature and the second feature are not in direct contact with each other, but are contacted via an additional feature formed therebetween. Furthermore, a first feature "on," "above," or "on top of" a second feature may include an embodiment in which the first feature is right or obliquely "on," "above," or "on top of" the second feature, or just means that the first feature is at a height higher than that of the second feature. While a first feature "below," "under," or "on bottom of" a second feature may include an embodiment in which the first feature is right or obliquely "below," "under," or "on bottom of" the second feature, or just means that the first feature is at a height lower than that of the second feature.

Reference throughout the present invention to "an embodiment," "some embodiments," "an example," "a specific example," or "some examples," means that a particular feature, structure, material, or characteristic described in connection with the embodiment or example is included in at least one embodiment or example of the present invention. Thus, the appearances of the phrases in various places throughout this specification are not necessarily referring to the same embodiment or example of the present invention. Furthermore, the particular features, structures, materials, or characteristics may be combined in any suitable manner in one or more embodiments or examples. In addition, without conflicting, various embodiments or examples or features of various embodiments or examples described in the present specification may be combined by those skilled in the art, within the scope of the claims.

## Claims

1. An electronic device (100), comprising:
a pivot shaft (4) having a metal portion;
a first body (21) and a second body (22), wherein the first body (21) and the second body (22) are rotatably connected relative to each other through the pivot shaft (4), the first body (21) comprising a first motherboard (211), the second body (22) comprising a second motherboard (221); and
a radio-frequency transmission line (1), wherein the radio-frequency transmission line (1) has a first end coupled to the first motherboard (211) and a second end coupled to the second motherboard (221),
wherein the radio-frequency transmission line (1) comprises:
at least one band-shaped line segment (11) and at least two coplanar waveguide segments (12), the one band-shaped line segment (11) being located between the two coplanar waveguide segments (12) in an extending direction of the radio-frequency transmission line (1), the band-shaped line segment (11) being coupled to the coplanar waveguide segments (12), wherein
the one band-shaped line segment (11) is coupled to the pivot shaft (4) to remain stationary relative to the pivot shaft (4), and the coplanar waveguide segments (12) are spaced apart from the metal portion;
a first metal ground assembly (150) comprising a first modified polyimide layer (133) and a first metal ground layer (132) arranged on the first modified polyimide layer (133);
a second metal ground assembly (151) comprising a second modified polyimide layer (139) and a second metal ground layer (138) arranged on the second modified polyimide layer (139); and
a metal trace assembly (152) comprising a third modified polyimide layer (136) and a metal trace layer (135) arranged on the third modified polyimide layer (136), the first metal ground layer (132), the first modified polyimide layer (133), the metal trace layer (135), the third modified polyimide layer (136), the second metal ground layer (138) and the second modified polyimide layer (139) being arranged sequentially in a thickness direction of the radio-frequency transmission line (1), wherein the first metal ground layer (132) has a first through hole (1321) therethrough in the thickness direction, the second metal ground layer (138) has a second through hole (1381) therethrough in the thickness direction, the first through hole (1321) and the second through hole (1381) are opposite each other in the thickness direction, a portion of the radio-frequency transmission line (1) opposite the first through hole (1321) in the thickness direction constitutes the coplanar waveguide segment (12), and the band-shaped line segment (11) of the radio-frequency transmission line (1) is staggered with the first through hole (1321) in the thickness direction.

2. The electronic device (100)according to claim 1, wherein the radio-frequency transmission line (1) comprises 2N+1 band-shaped line segments (11) and 2N coplanar waveguide segments (12) arranged alternately and connected sequentially in the extending direction, wherein N is an integer greater than or equal to 1, each coplanar waveguide segment (12) is located between two adjacent band-shaped line segments (11) in the extending direction.

3. The electronic device (100) according to claim 2, wherein
the band-shaped line segments (11) comprises a first band-shaped line segment (11a), a second band-shaped line segment (11b) and a third band-shaped line segment (11c) arranged sequentially in the extending direction;
the coplanar waveguide segments (12) comprising:
a first coplanar waveguide segment (12a) located between the first band-shaped line segment (11a) and the second band-shaped line segment (11b) in the extending direction, the first coplanar waveguide segment (12a) being coupled to each of the first band-shaped line segment (11a) and the second band-shaped line segment (11b); and
a second coplanar waveguide segment (12b) located between the second band-shaped line segment (11b) and the third band-shaped line segment (11c) in the extending direction, the second coplanar waveguide segment (12b) being coupled to each of the second band-shaped line segment (11b) and the third band-shaped line segment (11c).

4. The electronic device (100)according to claim 3, wherein each of the first coplanar waveguide segment (12a) and the second coplanar waveguide segment (12b) has a length less than or equal to a first preset value.

5. The electronic device (100)according to claim 2, wherein
the band-shaped line segments (11) comprises a first band-shaped line segment (11a), a second band-shaped line segment (11b), a third band-shaped line segment (11c), a fourth band-shaped line segment (11d) and a fifth band-shaped line segment (11e) arranged sequentially in the extending direction;
the coplanar waveguide segments (12) comprising:
a first coplanar waveguide segment (12a) located between the first band-shaped line segment (11a) and the second band-shaped line segment (11b) in the extending direction, the first coplanar waveguide segment (12a) being coupled to each of the first band-shaped line segment (11a) and the second band-shaped line segment (11b);
a second coplanar waveguide segment (12b) located between the second band-shaped line segment (11b) and the third band-shaped line segment (11c) in the extending direction, the second coplanar waveguide segment (12b) being coupled to each of the second band-shaped line segment (11b) and the third band-shaped line segment (11c);
a third coplanar waveguide segment (12c) located between the third band-shaped line segment (11c) and the fourth band-shaped line segment (11d) in the extending direction, the third coplanar waveguide segment (12c) being coupled to each of the third band-shaped line segment (11c) and the fourth band-shaped line segment (11d); and
a fourth coplanar waveguide segment (12d) located between the fourth band-shaped line segment (11d) and the fifth band-shaped line segment (11e) in the extending direction, the fourth coplanar waveguide segment (12d) being coupled to each of the fourth band-shaped line segment (11d) and the fifth band-shaped line segment (11e).

6. The electronic device (100) according to claim 5, wherein each of the first coplanar waveguide segment (12a), the second coplanar waveguide segment (12b), the third coplanar waveguide segment (12c) and the fourth coplanar waveguide segment (12d) has a length greater than or equal to a second preset value and less than or equal to a third preset value.

7. The electronic device (100) according to claim 5 or 6, wherein each of the second band-shaped line segment (11b) and the fourth band-shaped line segment (11d) has a length less than or equal to a fourth preset value.

## Patentansprüche

1. Elektronische Vorrichtung (100), umfassend:
eine Drehachse (4) mit einem Metallabschnitt;
einen ersten Körper (21) und einen zweiten Körper (22), wobei der erste Körper (21) und der zweite Körper (22) über die Drehachse (4) relativ zueinander drehbar verbunden sind, der erste Körper (21) eine erste Hauptplatine (211) umfasst und der zweite Körper (22) eine zweite Hauptplatine (221) umfasst; und
eine Hochfrequenz-Übertragungsleitung (1), wobei die Hochfrequenz-Übertragungsleitung (1) ein erstes Ende, das mit der ersten Hauptplatine (211) gekoppelt ist, und ein zweites Ende, das mit der zweiten Hauptplatine (221) gekoppelt ist, aufweist,
wobei die Hochfrequenz-Übertragungsleitung (1) umfasst:
mindestens ein bandförmiges Leitungssegment (11) und mindestens zwei koplanare Wellenleitersegmente (12), wobei sich das eine bandförmige Leitungssegment (11) in einer Erstreckungsrichtung der Hochfrequenz-Übertragungsleitung (1) zwischen den zwei koplanaren Wellenleitersegmenten (12) befindet und das bandförmige Leitungssegment (11) mit den koplanaren Wellenleitersegmenten (12) gekoppelt ist, wobei das eine bandförmige Leitungssegment (11) mit der Drehachse (4) gekoppelt ist, um relativ zur Drehachse (4) ortsfest zu bleiben, und die koplanaren Wellenleitersegmente (12) von dem Metallabschnitt beabstandet sind;
eine erste Metallerdungsanordnung (150), umfassend eine erste modifizierte Polyimidschicht (133) und eine erste Metallerdungsschicht (132), die auf der ersten modifizierten Polyimidschicht (133) angeordnet ist;
eine zweite Metallerdungsanordnung (151), umfassend eine zweite modifizierte Polyimidschicht (139) und eine zweite Metallerdungsschicht (138), die auf der zweiten modifizierten Polyimidschicht (139) angeordnet ist; und
eine Metallleiterbahnanordnung (152), umfassend eine dritte modifizierte Polyimidschicht (136) und eine Metallleiterbahnschicht (135), die auf der dritten modifizierten Polyimidschicht (136) angeordnet ist, wobei die erste Metallerdungsschicht (132), die erste modifizierte Polyimidschicht (133), die Metallleiterbahnschicht (135), die dritte modifizierte Polyimidschicht (136), die zweite Metallerdungsschicht (138) und die zweite modifizierte Polyimidschicht (139) in einer Dickenrichtung der Hochfrequenz-Übertragungsleitung (1) sequentiell angeordnet sind, wobei die erste Metallerdungsschicht (132) eine erste Durchgangsöffnung (1321) in der Dickenrichtung aufweist, die zweite Metallerdungsschicht (138) eine zweite Durchgangsöffnung (1381) in der Dickenrichtung aufweist, die erste Durchgangsöffnung (1321) und die zweite Durchgangsöffnung (1381) in der Dickenrichtung einander gegenüberliegen, ein Abschnitt der Hochfrequenz-Übertragungsleitung (1), der der ersten Durchgangsöffnung (1321) in der Dickenrichtung gegenüberliegt, das koplanare Wellenleitersegment (12) bildet und das bandförmige Leitungssegment (11) der Hochfrequenz-Übertragungsleitung (1) in der Dickenrichtung versetzt zur ersten Durchgangsöffnung (1321) angeordnet ist.

2. Elektronische Vorrichtung (100) nach Anspruch 1, wobei die Hochfrequenz-Übertragungsleitung (1) 2N+1 bandförmige Leitungssegmente (11) und 2N koplanare Wellenleitersegmente (12) umfasst, die abwechselnd und in der Erstreckungsrichtung aufeinanderfolgend angeordnet und verbunden sind, wobei N eine ganze Zahl größer oder gleich 1 ist und jedes koplanare Wellenleitersegment (12) in der Erstreckungsrichtung zwischen zwei benachbarten bandförmigen Leitungssegmenten (11) angeordnet ist.

3. Elektronische Vorrichtung (100) nach Anspruch 2, wobei
die bandförmigen Leitungssegmente (11) ein erstes bandförmiges Leitungssegment (11a), ein zweites bandförmiges Leitungssegment (11b) und ein drittes bandförmiges Leitungssegment (11c) umfassen, die in der Erstreckungsrichtung aufeinanderfolgend angeordnet sind;
die koplanaren Wellenleitersegmente (12) umfassen:
ein erstes koplanares Wellenleitersegment (12a), das in der Erstreckungsrichtung zwischen dem ersten bandförmigen Leitungssegment (11a) und dem zweiten bandförmigen Leitungssegment (11b) angeordnet ist, wobei das erste koplanare Wellenleitersegment (12a) mit dem ersten bandförmigen Leitungssegment (11a) und dem zweiten bandförmigen Leitungssegment (11b) gekoppelt ist; und
ein zweites koplanares Wellenleitersegment (12b), das in der Erstreckungsrichtung zwischen dem zweiten bandförmigen Leitungssegment (11b) und dem dritten bandförmigen Leitungssegment (11c) angeordnet ist, wobei das zweite koplanare Wellenleitersegment (12b) mit dem zweiten bandförmigen Leitungssegment (11b) und dem dritten bandförmigen Leitungssegment (11c) gekoppelt ist.

4. Elektronische Vorrichtung (100) nach Anspruch 3, wobei das erste koplanare Wellenleitersegment (12a) und das zweite koplanare Wellenleitersegment (12b) jeweils eine Länge aufweisen, die kleiner oder gleich einem ersten vorgegebenen Wert ist.

5. Elektronische Vorrichtung (100) nach Anspruch 2, wobei
die bandförmigen Leitungssegmente (11) ein erstes bandförmiges Leitungssegment (11a), ein zweites bandförmiges Leitungssegment (11b), ein drittes bandförmiges Leitungssegment (11c), ein viertes bandförmiges Leitungssegment (11d) und ein fünftes bandförmiges Leitungssegment (11e) umfassen, die in der Erstreckungsrichtung aufeinanderfolgend angeordnet sind;
die koplanaren Wellenleitersegmente (12) umfassen:
ein erstes koplanares Wellenleitersegment (12a), das in der Erstreckungsrichtung zwischen dem ersten bandförmigen Leitungssegment (11a) und dem zweiten bandförmigen Leitungssegment (11b) angeordnet ist, wobei das erste koplanare Wellenleitersegment (12a) mit dem ersten bandförmigen Leitungssegment (11a) und dem zweiten bandförmigen Leitungssegment (11b) gekoppelt ist;
ein zweites koplanares Wellenleitersegment (12b), das in der Erstreckungsrichtung zwischen dem zweiten bandförmigen Leitungssegment (11b) und dem dritten bandförmigen Leitungssegment (11c) angeordnet ist, wobei das zweite koplanare Wellenleitersegment (12b) mit dem zweiten bandförmigen Leitungssegment (11b) und dem dritten bandförmigen Leitungssegment (11c) gekoppelt ist;
ein drittes koplanares Wellenleitersegment (12c), das in der Erstreckungsrichtung zwischen dem dritten bandförmigen Leitungssegment (11c) und dem vierten bandförmigen Leitungssegment (11d) angeordnet ist, wobei das dritte koplanare Wellenleitersegment (12c) mit dem dritten bandförmigen Leitungssegment (11c) und dem vierten bandförmigen Leitungssegment (11d) gekoppelt ist; und
ein viertes koplanares Wellenleitersegment (12d), das in der Erstreckungsrichtung zwischen dem vierten bandförmigen Leitungssegment (11d) und dem fünften bandförmigen Leitungssegment (11e) angeordnet ist, wobei das vierte koplanare Wellenleitersegment (12d) mit dem vierten bandförmigen Leitungssegment (11d) und dem fünften bandförmigen Leitungssegment (11e) gekoppelt ist.

6. Elektronische Vorrichtung (100) nach Anspruch 5, wobei das erste koplanare Wellenleitersegment (12a), das zweite koplanare Wellenleitersegment (12b), das dritte koplanare Wellenleitersegment (12c) und das vierte koplanare Wellenleitersegment (12d) jeweils eine Länge aufweisen, die größer oder gleich einem zweiten vorgegebenen Wert und kleiner oder gleich einem dritten vorgegebenen Wert ist.

7. Elektronische Vorrichtung (100) nach Anspruch 5 oder 6, wobei das zweite bandförmige Leitungssegment (11b) und das vierte bandförmige Leitungssegment (11d) jeweils eine Länge aufweisen, die kleiner oder gleich einem vierten vorgegebenen Wert ist.

## Revendications

1. Dispositif électronique (100), comprenant :
un axe de pivotement (4) comportant une partie métallique ;
un premier corps (21) et un deuxième corps (22), le premier corps (21) et le deuxième corps (22) étant reliés de manière rotative l'un par rapport à l'autre par l'intermédiaire de l'axe de pivotement (4), le premier corps (21) comprenant une première carte mère (211), le deuxième corps (22) comprenant une deuxième carte mère (221) ; et
une ligne de transmission radiofréquence (1), la ligne de transmission radiofréquence (1) ayant une première extrémité couplée à la première carte mère (211) et une deuxième extrémité couplée à la deuxième carte mère (221),
dans lequel la ligne de transmission radiofréquence (1) comprend :
au moins un segment de ligne en forme de bande (11) et au moins deux segments de guide d'ondes coplanaires (12), ledit segment de ligne en forme de bande (11) étant situé entre les deux segments de guide d'ondes coplanaires (12) dans une direction d'extension de la ligne de transmission radiofréquence (1), le segment de ligne en forme de bande (11) étant couplé aux segments de guide d'ondes coplanaires (12), ledit segment de ligne en forme de bande (11) étant couplé à l'axe de pivotement (4) de manière à rester fixe par rapport à l'axe de pivotement (4), et les segments de guide d'ondes coplanaires (12) étant espacés de la partie métallique ;
un premier ensemble de masse métallique (150) comprenant une première couche de polyimide modifiée (133) et une première couche de masse métallique (132) disposée sur la première couche de polyimide modifiée (133) ;
un deuxième ensemble de masse métallique (151) comprenant une deuxième couche de polyimide modifiée (139) et une deuxième couche de masse métallique (138) disposée sur la deuxième couche de polyimide modifiée (139) ; et
un ensemble de piste métallique (152) comprenant une troisième couche de polyimide modifiée (136) et une couche de piste métallique (135) disposée sur la troisième couche de polyimide modifiée (136), la première couche de masse métallique (132), la première couche de polyimide modifiée (133), la couche de piste métallique (135), la troisième couche de polyimide modifiée (136), la deuxième couche de masse métallique (138) et la deuxième couche de polyimide modifiée (139) étant disposées séquentiellement dans une direction d'épaisseur de la ligne de transmission radiofréquence (1), la première couche de masse métallique (132) comportant un premier trou traversant (1321) la traversant dans la direction d'épaisseur, la deuxième couche de masse métallique (138) comportant un deuxième trou traversant (1381) la traversant dans la direction d'épaisseur, le premier trou traversant (1321) et le deuxième trou traversant (1381) étant opposés l'un à l'autre dans la direction d'épaisseur, une partie de la ligne de transmission radiofréquence (1) opposée au premier trou traversant (1321) dans la direction d'épaisseur constituant le segment de guide d'ondes coplanaire (12), et le segment de ligne en forme de bande (11) de la ligne de transmission radiofréquence (1) étant décalé par rapport au premier trou traversant (1321) dans la direction d'épaisseur.

2. Dispositif électronique (100) selon la revendication 1, dans lequel la ligne de transmission radiofréquence (1) comprend 2N+1 segments de ligne en forme de bande (11) et 2N segments de guide d'ondes coplanaires (12) disposés alternativement et connectés séquentiellement dans la direction d'extension, N étant un nombre entier supérieur ou égal à 1, chaque segment de guide d'ondes coplanaire (12) étant situé entre deux segments de ligne en forme de bande (11) adjacents dans la direction d'extension.

3. Dispositif électronique (100) selon la revendication 2, dans lequel
les segments de ligne en forme de bande (11) comprennent un premier segment de ligne en forme de bande (11a), un deuxième segment de ligne en forme de bande (11b) et un troisième segment de ligne en forme de bande (11c) disposés séquentiellement dans la direction d'extension ;
les segments de guide d'ondes coplanaires (12) comprenant :
un premier segment de guide d'ondes coplanaire (12a) situé entre le premier segment de ligne en forme de bande (11a) et le deuxième segment de ligne en forme de bande (11b) dans la direction d'extension, le premier segment de guide d'ondes coplanaire (12a) étant couplé à chacun du premier segment de ligne en forme de bande (11a) et du deuxième segment de ligne en forme de bande (11b) ; et
un deuxième segment de guide d'ondes coplanaire (12b) situé entre le deuxième segment de ligne en forme de bande (11b) et le troisième segment de ligne en forme de bande (11c) dans la direction d'extension, le deuxième segment de guide d'ondes coplanaire (12b) étant couplé à chacun du deuxième segment de ligne en forme de bande (11b) et du troisième segment de ligne en forme de bande (11c).

4. Dispositif électronique (100) selon la revendication 3, dans lequel chacun du premier segment de guide d'ondes coplanaire (12a) et du deuxième segment de guide d'ondes coplanaire (12b) présente une longueur inférieure ou égale à une première valeur prédéterminée.

5. Dispositif électronique (100) selon la revendication 2, dans lequel
les segments de ligne en forme de bande (11) comprennent un premier segment de ligne en forme de bande (11a), un deuxième segment de ligne en forme de bande (11b), un troisième segment de ligne en forme de bande (11c), un quatrième segment de ligne en forme de bande (11d) et un cinquième segment de ligne en forme de bande (11e) disposés séquentiellement dans la direction d'extension ;
les segments de guide d'ondes coplanaires (12) comprenant :
un premier segment de guide d'ondes coplanaire (12a) situé entre le premier segment de ligne en forme de bande (11a) et le deuxième segment de ligne en forme de bande (11b) dans la direction d'extension, le premier segment de guide d'ondes coplanaire (12a) étant couplé à chacun du premier segment de ligne en forme de bande (11a) et du deuxième segment de ligne en forme de bande (11b) ;
un deuxième segment de guide d'ondes coplanaire (12b) situé entre le deuxième segment de ligne en forme de bande (11b) et le troisième segment de ligne en forme de bande (11c) dans la direction d'extension, le deuxième segment de guide d'ondes coplanaire (12b) étant couplé à chacun du deuxième segment de ligne en forme de bande (11b) et du troisième segment de ligne en forme de bande (11c) ;
un troisième segment de guide d'ondes coplanaire (12c) situé entre le troisième segment de ligne en forme de bande (11c) et le quatrième segment de ligne en forme de bande (11d) dans la direction d'extension, le troisième segment de guide d'ondes coplanaire (12c) étant couplé à chacun du troisième segment de ligne en forme de bande (11c) et du quatrième segment de ligne en forme de bande (11d) ; et
un quatrième segment de guide d'ondes coplanaire (12d) situé entre le quatrième segment de ligne en forme de bande (11d) et le cinquième segment de ligne en forme de bande (11e) dans la direction d'extension, le quatrième segment de guide d'ondes coplanaire (12d) étant couplé à chacun du quatrième segment de ligne en forme de bande (11d) et du cinquième segment de ligne en forme de bande (11e).

6. Dispositif électronique (100) selon la revendication 5, dans lequel chacun du premier segment de guide d'ondes coplanaire (12a), du deuxième segment de guide d'ondes coplanaire (12b), du troisième segment de guide d'ondes coplanaire (12c) et du quatrième segment de guide d'ondes coplanaire (12d) présente une longueur supérieure ou égale à une deuxième valeur prédéterminée et inférieure ou égale à une troisième valeur prédéterminée.

7. Dispositif électronique (100) selon la revendication 5 ou 6, dans lequel chacun du deuxième segment de ligne en forme de bande (11b) et du quatrième segment de ligne en forme de bande (11d) présente une longueur inférieure ou égale à une quatrième valeur prédéterminée.
